## Europäisches Patentamt
## European Patent Office
## Office européen des brevets

(11) Veröffentlichungsnummer: **0 254 962 B1**

# (12) EUROPÄISCHE PATENTSCHRIFT

(45) Veröffentlichungstag der Patentschrift: **18.12.91**

(51) Int. Cl.⁵: **C25D 17/00**

(21) Anmeldenummer: **87110231.5**

(22) Anmeldetag: **15.07.87**

(54) Galvanisiereinrichtung für plattenförmige Werkstücke, insbesondere Leiterplatten.

(30) Priorität: **28.07.86 DE 3625483**

(43) Veröffentlichungstag der Anmeldung:
**03.02.88 Patentblatt 88/05**

(45) Bekanntmachung des Hinweises auf die
Patenterteilung:
**18.12.91 Patentblatt 91/51**

(84) Benannte Vertragsstaaten:
**AT BE CH DE FR GB IT LI NL SE**

(56) Entgegenhaltungen:
**EP-A- 0 254 030        DE-A- 2 134 923
US-A- 2 074 220        US-A- 2 074 221
US-A- 2 171 437        US-A- 3 643 670**

(73) Patentinhaber: **SIEMENS AKTIENGESELL-
SCHAFT
Wittelsbacherplatz 2
W-8000 München 2(DE)**

(72) Erfinder: **Hosten, Daniel
Staatsbaan 147
B-8120 Handzame, (Kortemark)(BE)**

**Beschreibung**

Die Erfindung betrifft eine Galvanisiereinrichtung für im horizontalen Durchlauf zu behandelnde plattenförmige Werkstücke, insbesondere Leiterplatten, mit mindestens einer in der Elektrolytlösung angeordneten Anode und mit mindestens einer seitlich angeordneten Kontaktiervorrichtung zur kathodischen Kontaktierung der durchlaufenden Werkstücke.

Eine derartige Galvanisiereinrichtung ist aus der DE-A- 32 36 545 bekannt. Bei der dort beschriebenen Einrichtung werden die plattenförmigen Werkstücke horizontal durch die Elektrolytlösung geführt. Der Vorschub der Werkstücke erfolgt über angetriebene Kontakträder, die auf einer Seite in der Behandlungszelle angeordnet sind und gleichzietig auch als Kontaktiervorrichtung zur kathodischen Kontaktierung der Werkstücke dienen. Zum Schutz der Kontakträder vor der Elektrolytlösung sind sich in Durchlaufrichtung erstreckende Abschirmungen mit an dem jeweiligen Werkstück anliegenden Dichtleisten vorgesehen. Auf der den Kontakträdern gegenüberliegenden Seite der Behandlungszelle ist der Führung und Halterung der Werkstücke eine besondere Gletibefestigung angeordnet.

Bei der vorstehend geschilderten Galvanisiereinrichtung kann auch die Verwendung einer Dichtung den Zutritt von Elektrolytlösung zum seitlichen Kontaktierungsbereich der Werkstücke und zu den Kontakträdern nicht vollständig verhindern. Als Folge dieser unvollständigen Abdichtungen kommt es zu schwammigen Metallabscheidungen im Kontaktbereich, zu einer rapiden Verschlechterung der Rollkontakte und zu ungünstigen Schichtdickenverteilungen der galvanisch abgeschiedenen Metallschichten bzw. zu einer starken Streuung der Schichtdicke.

In der älteren, nicht vorveröffentlichten europäischen Patentanmeldung entsprechend der EP-A-0254030 wird eine Galvanisiereinrichtung für im horizontalen Durchlauf zu behandelnde plattenförmige Werkstücke, wie Leiterplatten, vorgeschlagen, bei welcher die Transporteinrichtung für den kontinuierlichen Transport der Werkstücke durch die Elektrolytlösung als eine endlos umlaufende, angetriebene Reihe einzelner Transportorgane ausgebildet ist, welche die Seitenränder der plattenförmigen Werkstücke festhalten und in der Transportrichtung bewegen. Dabei sind zu Beginn und Ende des Transportweges Mittel vorgesehen, die ein Erfassen der plattenförmigen Werkstücke durch die Transportorgane, bzw. das Freigeben der plattenförmigen Gegenstände durch die Transportorgane bewirken. Die Transportorgane können auch zugleich der Stromzuführung zu den plattenförmigen Werkstücken dienen.

Aus der US-A-3643670 ist eine Galvanisiereinrichtung bekannt, bei welcher dünne Streifen derart auf einer horizontalen Bahn geführt werden, daß nur die unteren, in die Elektrolytlösung eintauchenden Bereiche der Streifen galvanisiert werden. Als Transport- und Kontaktierorgane dienen an einer endlos umlaufenden Kette angebrachte Klemmen, die den oberen Rand der Streifen festhalten und in der Transportrichtung bewegen. Dabei sind zu Beginn und Ende des Transportweges Schienen vorgesehen, die ein Erfassen der Streifen durch die Klemmen bzw. das Freigeben der Streifen durch die Klemmen bewirken.

Aus der DE-A-2134923 ist eine Galvanisiereinrichtung bekannt, bei welcher Werkstücke, wie z. B. Schneidelemente für Kettensägen, auf einer horizontalen Bahn durch die Elektrolytlösung geführt werden. Als Transport- und Kontaktierorgan dient eine endlos umlaufende Kette, an deren bügelförmigen Gliedern federnde Werkstückshalter befestigt sind. Einlaufseitig sind im Bereich von Beschichtungsvorrichtungen Mittel zum Öffnen der federnden Werkstückshalter vorgesehen, während auslaufseitig angeordnete Löseeinrichtungen die Freigabe der Werkstücke bewirken.

Der Erfindung liegt die Aufgabe zugrunde, bei einer Galvanisiereinrichtung der eingangs genannten Art die kathodische Kontaktierung der Werkstücke zu verbessern.

Diese Aufgabe wird erfindungsgemäß durch die im Patentanspruch 1 angegebenen Merkmale gelöst.

Der Erfindung liegt die Erkenntnis zugrunde, daß Rollkontakte aber auch Schleifkontakte gegenüber einer Berührung mit Elektrolytlösung besonders empfindlich sind und daß ein Klemmkontakt in dieser Beziehung weitaus weniger Schwierigkeiten bereit. Um eine Klemmkontaktierung der Werkstücke durch zangenförmige Kontaktklemmen realisieren zu können, müssen diese Kontaktklemmen dann aber synchron mit dem jeweils durchlaufenden Werkstück verfahren werden. Trotz der erforderlichen Verfahrbarkeit der Kontaktklemmen bereitet dann die Zufuhr des Kathodenstroms zu den Kontaktklemmen keine Probleme, da die entsprechende Kontaktierung nun in einen vor dem Zutritt von Elektrolytlösung und anderen negativen Einflüssen geschützen Bereich verlegt werden kann.

Eine weitere Verbesserung der Kontaktierung der durchlaufenden Werkstücke kann dadurch erreicht werden, daß mehrere in Abstand zueinander seitlich mit dem Werkstück verfahrbare Kontaktklemmen vorgesehen sind. Außerdem führt die Kontaktierung an mehreren Stellen insbesondere bei Leiterplatten mit einer relativ dünnen Kaschierung zu einer erheblichen Verbesserung der Schichtdickenverteilung. Demzufolge ist es dann auch besonders günstig, wenn zu beiden Seiten der Durchlaufbahn mit dem Werkstück verfahrbare Kontaktklemmen vorgesehen sind.

Gemäß einer besonders bevorzugten Ausgestaltung der Erfindung ist vorgesehen, daß auf mindestens einer Seite der Durchlaufbahn mindestens ein endloser Trieb als verfahrbarer Träger zangenförmiger Kontaktklemmen angeordnet ist. Ein derartiger endloser Trieb, der durch seinen geringen Platzbedarf besonders gut für die Unterbringung in einer Galvanisiereinrichtung geeignet ist, gewährleistet auf sehr einfache Weise die erforderliche Beweglichkeit der zangenförmigen Kontaktklemmen.

Als endloser Trieb kann eine Kette verwendet werden. Im Hinblick auf die Korrosionsbeständigkeit und Flexibilität ergeben sich jedoch auch erhebliche Vorteile, wenn der endlose Trieb durch mindestens einen Zahnriemen gebildet ist. In diesem Fall ist es dan auch möglich, daß den oberen Klemmbacken der Kontaktklemmen ein oberer Zahnriemen zugeordnet ist und daß den unteren Klemmbacken der Kontaktklemmen ein unterer Zahnriemen zugeordnet ist. Eine derartige Aufteilung in einen oberen und einen unteren Zahnriemen bietet dann insbesondere bei der Zufuhr des Kathodenstroms zu den Klemmbacken Vorteile, da der Raum zwischen den Zahnriemen für die Kontaktierung genutzt werden kann.

Gemäß einer weiteren besonders bevorzugten Ausgestaltung der Erfindung ist vorgesehen, daß der endlose Trieb antreibbar ist und mit den zangenförmigen Kontaktklemmen als Mitnehmer eine Transporteinrichtung für den horizontalen Durchlauf der Werkstücke bildet. Durch eine derartige Kombination von Kontaktiervorrichtung und Transporteinrichtung ergibt sich ein besonders einfacher Aufbau der gesamten Galvanisiereinrichtung.

Ein weiterer wesentlicher Vorteil der Verwendung eines endlosen Triebes besteht darin, daß im Bereich des rücklaufenden Trums des endlosen Triebes mindestens eine Reinigungs-Einrichtung zur mechanischen und/oder chemischen Reinigung der Kontaktflächen der Kontaktklemmen angeordnet ist. Mit Hilfe derartiger Reinigungs-Einrichtungen, bei welchen es sich beispeilsweise um Bürsten, Schleifsteine, Ätzmittelbäder oder Sprühdüsen für Ätzlösung handeln kann, kann dann eventuell auf den Kontaktflächen der Kontaktklemmen abgeschiedenes Metall entfernt werden. Die derart bei jedem Umlauf des endlosen Triebes gereinigten Kontaktflächen gewährleisten eine äußerst hohe Zuverlässigkeit der Kontaktierung.

Es hat sich auch als zweckmäßig erwiesen, wenn der Kathodenstrom den Kontaktklemmen mittels Schleifkontaktierung zuführbar ist. In diesem Fall kann die Schleifkontaktierung als sehr zuverlässige Kontaktierung angesehen werden, da sie an dem für sie vorgesehenen Ort nicht durch den Zutritt von Elektrolytlösung beeinträchtigt werden kann.

Ist der Kathodenstrom der Oberseite und der Unterseite der Werkstücke separat, d. h. über getrennte Gleichrichter zuführbar, so können die Schichtdicken der galvanischen Metallabscheidung auf der Ober- und Unterseite der Werkstücke getrennt beeinflußt werden.

Ist der Kathodenstrom den beiden Seiten der Werkstücke separat zuführbar, so können insbesondere bei Leiterplatten mit weniger als 10 $\mu$m starken Kaschierungen über die Plattenbreite gesehen noch gleichmäßigere Schichtdickenverteilungen erzielt werden.

Der Kathodenstrom kann auch in Durchlaufrichtung der Werkstücke gesehen über mindesten zwei separate Längenabschnitte zugeführt werden. Durch diese Maßnahme können dann beispielsweise im Einlaufbereich von Leiterplatten geringe Stromdichten gewählt werden, bei denen Verbrennungen von stromlos abgeschiedenen Kupferschichten mit Sicherheit ausgeschlossen werden können.

Eine separate Beeinflussung der Metallabscheidung auf Ober- und Unterseite der Werkstücke kann auf einfache Weise dadurch realisiert werden, daß der Kathodenstrom den oberen Klemmbacken der Kontaktklemmen über eine obere Stromschiene und den unteren Klemmbacken der Kontaktklemmen über eine untere Stromschiene zuführbar ist. Die obere Stromschiene und die untere Stromschiene können dann zweckmäßigersweise derart angeordnet werden, daß sie gleichzeitig als Kulisse zum Schließen der Kontaktklemmen im Galvanisierbereich dienen.

Gemäß einer bevorzugten Variante des Kontaktierungskonzepts ist vorsehen, daß der Kathodenstrom den oberen Klemmbacken der Kontaktklemmen über eine sich in Durchlaufrichtung erstreckende obere Bürste und den unteren Klemmbacken der Kontaktklemmen über eine sich in Durchlaufrichtung erstreckende untere Bürste zuführbar ist. Derartige Bürsten gewährleisten eine äußerst zuverlässige Kontaktierung. Außerdem kann dann eine unmittelbare Kontaktierung der Klemmbacken dadurch erreicht werden, daß der oberen Bürste an die oberen Klemmbacken rückseitig angeformte Stromabnehmer zugeordnet sind und daß der unteren Bürste an die unteren Klemmbacken rückseitig angeformte Stromabnehmer zugeordnet sind.

Eine weitere vorteilhafte Ausgestaltung der Erfindung sieht vor, daß der Kontaktdruck einer Kontaktklemme durch eine Schließfeder aufbringbar ist und daß zum Öffnen der Kontaktklemme im Ein- und Auslaufbereich der Werkstücke wirkende Kulissensteuerungen vorgesehen sind. Der Vorteil dieser Ausführungsform liegt in einem besonders gleichmäßigen Kontaktdruck. Das Öffnen kann dann auf einfache Weise dadurch realisiert werden, daß der Kulissensteuerung ein gegen die Kraft der Schließfeder wirkender Öffnungsbolzen der Kontaktklemme zugeordnet ist.

Schließlich ist es im Hinblick auf unerwünschte Metallabscheidungen im Kontaktierungsbereich besonders günstig, wenn die Kontaktklemmen durch eine seitlich sich in Durchlaufrichtung erstreckende und an dem jeweiligen Werkstück anliegende Dichtung vor dem Zutritt von Elektrolytlösung abgeschirmt sind.

Ausführungsbeispiele der Erfindung sind in der Zeichnung dargestellt und werden im folgenden näher beschrieben.

Es zeigen

Fig. 1 eine Horizontal-Durchlaufanlage zum Durchkontaktieren und Galvanisieren von Leiterplatten in stark vereinfachter schematischer Darstellung,

Fig. 2 eine perspektivische Darstellung der Galvanisiereinrichtung der in Fig. 1 dargestellten Horizontal-Durchlaufanlage,

Fig. 3 eine erste Ausführungsform einer Kontaktiervorrichtung mit an einer Kette angeordneten Kontaktklemmen,

Fig. 4 Einzelheiten des Kettenantriebes der in Fig. 3 dargestellten Kontaktiervorrichtung,

Fig. 5 eine zweite Ausführungsform einer Kontaktiervorrichtung mit an oberen und unteren Zahnriemen befestigten Kontaktklemmen,

Fig. 6 eine teilweise geschnittene Draufsicht auf die Kontaktiervorrichtung nach Fig. 5 und

Fig. 7 eine Seitenansicht der in den Figuren 5 und 6 dargestellten Kontaktiervorrichtung.

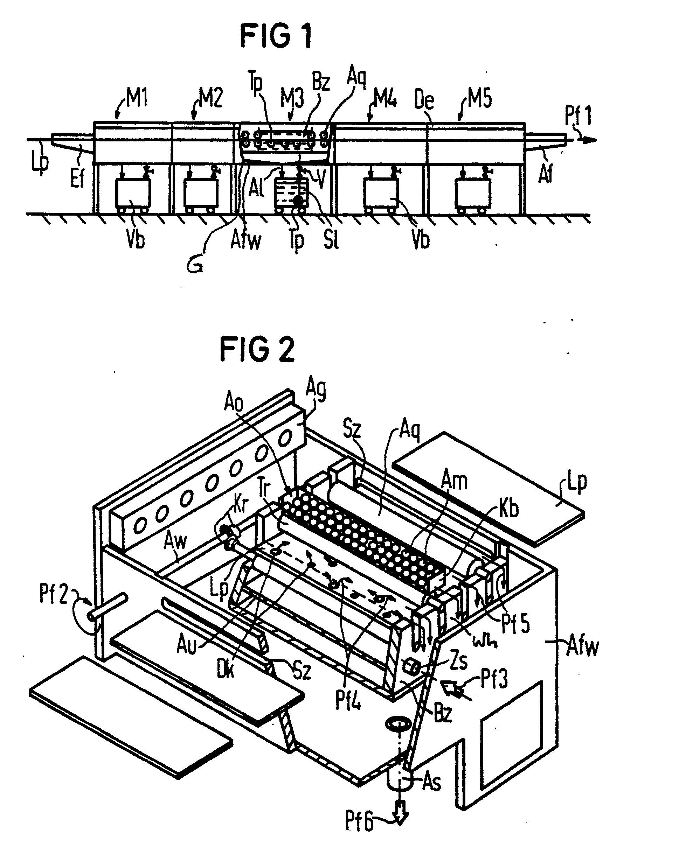

Fig. 1 zeigt das Grundprinzip einer in Modulbauweise aufgebauten Horizontal-Durchlaufanlage zum Durchkontaktieren und Galvanisieren von Leiterplatten. Die mit Lp bezeichneten Leiterplatten werden in einen Einlauf Ef eingegeben, durchlaufen dann nacheinander angeordnete Module M1 bis M5 um sodann die Durchlaufanlage über einen mit Af bezeichneten Auslauf in Richtung des Pfeiles Pf1 wieder zu verlassen.

Die gesamte Durchlaufanlage setzt sich aus drei Arten von Grundmodulen zusammen. In Fig. 1 sind mit den Modulen M1 bis M5 nur einige der in der Praxis tatsächlich eingesetzten Module aufgezeigt.

Jeder der Module M1 bis M5 besteht aus einer Auffangwanne Afw, einer Behandlungszelle Bz, dem Transportsystem für die Leiterplatten Lp und einen Vorratsbehälter Vb für die jeweils verwendete Behandlungsflüssigkeit.

Jede Auffangwanne Afw ist auf einem Grundgestell G angeordnet und nach außen durch einen Deckel De abgeschlossen. In der Auffangwanne Afw ist dann die zugeordnete Behandlungszelle Bz mit den erforderlichen Transportrollen Tp sowie einlaufseitig und auslaufseitig vorgesehenen Abquetschwalzen Aq angeordnet. Die in der Auffangwanne Afw aufgefangene Behandlungsflüssigkeit wird über eine Ablaufleitung Al in den darunter Angeordneten Vorratsbehälter Vb zurückgeführt. Über eine in dem fahrbaren Vorratsbehälter Vb angeordnete Tauchpumpe Tp und eine Steigleitung Sl wird die Behandlungsflüssigkeit in die Behandlungszelle Bz hochgepumpt. Die Einstellung der jeweils gewünschten Durchflußmenge erfolgt dabei über ein in der Steigleitung Sl angeordnetes Ventil V.

Wie bereits erwähnt wurde, setzt sich eine Durchlaufanlage aus drei Arten von Grundmodulen zusammen. Die Sprühmodule haben dabei die Aufgabe ein Einschleppen von Behandlungsflüssigkeiten in die nachfolgenden Bäder zu verhindern. Hierzu sind in der Auffangwanne oberhalb und unterhalb der Durchlaufbahn Düsenstöcke angeordnet. Die Spülmittelmengen des oberen und des unteren Düsensystems sind dabei über Ventile separat regelbar. Die bereits erwähnten Abquetschwalzen Aq, die eingangsseitig und ausgangsseitig paarweise angeordnet sind, verhindern das Vermischen von Spülmittel und Behandlungsflüssigkeit. Weitere Einzelheiten über derartige Sprühmodule gehen beispielsweise aus der DE-C- 30 11 061 hervor.

Als zweite Art von Grundmodulen sind die chemischen Behandlungsmodule zu nennen, die beispielsweise für die stromlose Verkupferung auf den Plattenoberflächen und in den Durchkontaktierungslöchern verwendet werden. Dabei gewährleistet ein Flutregister eine gleichmäßige Durchflutung durch alle Durchkontaktierungslöcher und ein gleichmäßiges Anströmen der gesamten Plattenoberfläche.

Als dritte Art von Grundmodulen werden schließlich Galvanisiermodule eingesetzt, die nachfolgend anhand der in Figur 2 dargestellten Galvanisiereinrichtung erläutert werden sollen.

Fig. 2 zeigt in einer teilweisen aufgebrochenen perspektivischen Darstellung Einzelheiten der Galvanisierung. Es ist zu erkennen, daß die beiden Stirnwände der Auffangwanne Afw in Höhe der Durchlaufbahn mit Schlitzen Sz versehen sind, die den Durchtritt der Leiterplatten Lp ermöglichen. Der Innenraum zwischen dem Deckel De (vgl. Fig. 1) und der Auffangwanne Afw ist auf einer Seite mit einer Absaugung Ag versehen, die zur Erzeugung eines Unterdrucks in diesem Raum an eine zentrale Absaugeinrichtung angeschlossen ist. Unterhalb der Absaugung Ag ist eine in Richtung des Pfeiles Pf2 antreibbare und in Längsrichtung angeordnete Antriebswelle Aw zu erkennen, welche die Transportrollen Tr und die unteren Abquetschwalzen Aq über entsprechend angeordnete Kegelräder Kr antreibt.

Die Zufuhr der aus dem Vorratsbehälter Vb (vgl. Fig. 1) hochgepumpten Elektrolytlösung erfolgt über einen seitlich in die Behandlungszelle Bz einmündenden Zufuhrstutzen Zs, so wie es durch den Pfeil Pf3 aufgezeigt ist. Die Zufuhr der Elektrolytlösung wird dabei so bemessen, daß durch die Durchkontaktierungslöcher Dk der Leiterplatten Lp eine nach oben gerichtete und durch die Pfeile Pf4 aufgezeigte Strömung entsteht. Durch diese ausgeprägte Strömung wird - sofern andere Voraussetzungen erfüllt sind - eine qualitativ hochwertige galvanische Verstärkung der Durchkontaktierungen gewährleistet. Die Elektrolytlösung durchströmt dann eine obere Anode Ao und fließt zum Teil in Richtung der Pfeile Pf5 über ein seitliches Wehr Wh in die Auffangwanne Afw. Die Auffangwanne Afw ist mit einem Ablaufstutzen As versehen, über welchen die aufgefangene Elektroyltlösung dann in Richtung des Pfeiles Pf6 wieder in den zugeordneten Vorratsbehälter Vb (vgl. Fig. 1) geführt wird.

Die bereits vorstehend erwähnte obere Anode Ao ist in geringem Abstand über der Durchlaufbahn der Leiterplatten Lp angeordnet und horizontal ausgerichtet. Sie besteht aus einem Korb Kb und darin in einer Lage oder in mehreren Lagen angeordnetem Anodenmaterial Am. Der Korb Kb besteht aus Titan, wobei der aus Streckmetall gebildete Boden für die Elektrolytlösung leicht durchlässig ist. Bei dem Anodenmaterial Am handelt es sich im vorliegenden Fall um Kupferkugeln, die häufig auch als Cu-Pellets bezeichnet werden. Es ist ohne weiteres zu erkennen, daß derartige Kupferkugeln nach dem Öffnen des Deckels De (vgl. Fig. 1) leicht ausgetauscht oder nachgefüllt werden können.

In geringem Abstand unter der Durchlaufbahn der Leiterplatte Lp ist eine ebenfalls horizontal ausgerichtete untere Anode Au angeordnet, die als Streckmetallsieb ausgebildet ist und aus platiniertem Titan besteht. Bei der unteren Anode Au handelt es sich also im Gegensatz zur oberen Anode Ao um eine unlösliche Anode, deren Abstand dadurch zur Durchlaufbahn der Leiterplatten Lp konstant bleibt. Durch die Ausbildung als Streckmetallsieb wird eine Behinderung des Elektrolytaustausches und der Strömung der elektrolytlösung ausgeschlossen.

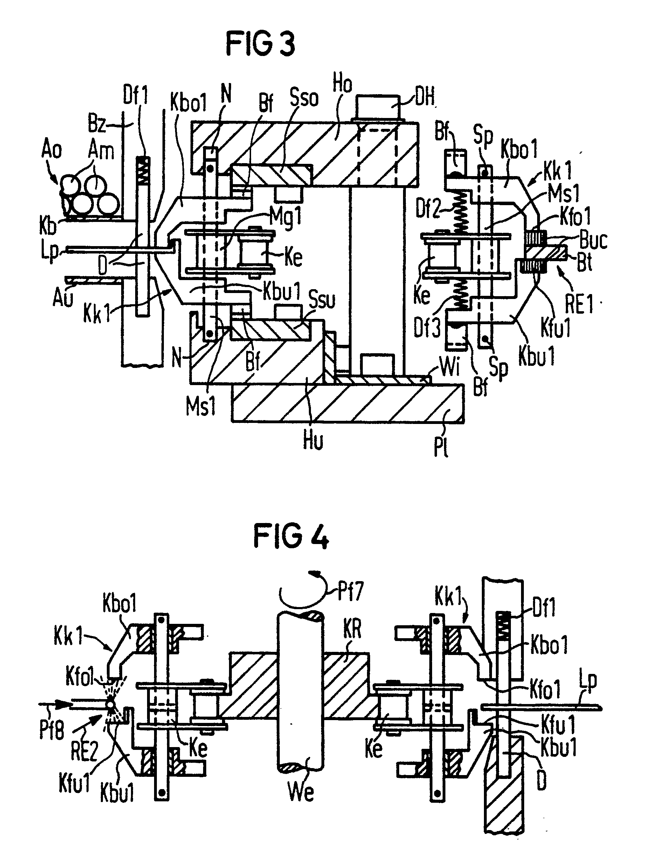

Die kathodische Kontaktierung der Leiterplatten Lp, die für den angestrebten Erfolg von maßgebender Bedeutung ist, wurde in Fig. 2 nicht aufgezeigt. Zwei verschiedene Ausführungsformen entsprechender Kontaktiervorrichtungen werden nachfolgend anhand der Fig. 3 und 4 sowie der Fig. 5, 6 und 7 erläutert.

Bei der in Fig. 3 dargestellten Kontaktiervorrichtung sind am linken Bildrand die seitliche Wandung der Behandlungszelle Bz, die obere Anode Ao mit dem Korb Kb und dem Anodenmaterial Am, die zu galvanisierende Leiterplatte Lp und die untere Anode Au zu erkennen. Die Leiterplatte Lp ist mit ihrem seitlichen Randbereich durch die Wandung der Behandlungszelle Bz hindurchgeführt, wobei die hierzu erforderliche, sich in Durchlaufrichtung schlitzförmig erstreckende Öffnung durch eine Dichtung D verschlossen ist. Die Dichtung D besteht aus einer unteren, fest angeordneten Dichtleiste und einer oberen, in vertikaler Richtung beweglichen Dichtleiste, die über Druckfedern Df1 gegen die Leiterplatte Lp gedrückt wird. Die beispielsweise aus Polytetrafluoräthylen bestehenden Dichtleisten der Dichtung D haben die Aufgabe sich an die Oberfläche der durchlaufenden Leiterplatten Lp anzuschmiegen und einen Austritt von Elektrolytlösung zumindest weitgehend zu verhindern.

Der über die Dichtung D seitlich überstehende Rand der Leiterplatten Lp wird zur kathodischen Kontaktierung von mehreren, im Abstand zueinander angeordneten und zangenförmig ausgebildeten Kontaktklemmen Kk1 erfaßt. Jede dieser Kontaktklemmen Kk1 besteht aus einer oberen Klemmbacke Kbo1 und einer unteren Klemmbacke Kbu1, wobei beide Klemmbacken auf einem vertikal ausgerichteten Mitnehmerstift Ms1 verschiebbar angeordnet sind. Der Mitnehmerstift Ms1 ist seinerseits in einem Mitnehmerglied Mg1 der mit Ke bezeichneten Kette eines Kettentriebes gehalten. Die Mitnehmerstifte Ms1 der einzelnen Kontaktklemmen Kk1 sind zusätzlich noch in U-förmigen Nuten N einer oberen Halteschiene Ho und einer unteren Halteschiene Hu geführt. Diese Längsführung beschränkt sich jedoch auf den Bereich in dem die Leiterplatten Lp kathodisch kontaktiert werden sollen und in dem der Kettentrieb mit den Kontaktklemmen Kk1 gleichzeitig die Aufgabe einer Transporteinrichtung für den horizontalen Durchlauf der Leiterplatten Lp erfüllt. Im Umlenkbereich des Kettentriebes und im Bereich des rücklaufenden Trums entfällt diese Führung. Die untere Halteschiene Hu ist mit einem Winkel Wi und einer Platte Pl zu einer festen Einheit verbunden, welche ihrerseits über mehrere Distanz- und Haltebolzen DH mit der oberen Halteschiene Ho starr verbunden ist.

Die obere Halteschiene Ho trägt an ihrer Unterseite eine obere Stromscheine Sso, während die untere Halteschiene Hu an ihrer Oberseite eine untere Stromschiene Ssu trägt. Die beiden Stromschienen Sso und Ssu bestehen beispielsweise aus Graphit oder Kupfer, während als Material für die beiden Halteschienen Ho und Hu hochmolekulares Polyäthylen besonders geeignet ist.

Die rückwärtigen Teile der oberen und unteren Klemmbacken Kbo1 und Kbu1 tragen mit Bf bezeichnete Blattfedern, die auf der oberen Stromschiene Sso bzw. der unteren Stromschiene Ssu gleiten. Der Abstand zwischen der oberen Stromschiene Sso und der unteren Stromschiene Ssu ist dabei derart bemessen daß die Blattfedern Bf zusammengedrückt werden und den über die obere Klemmbacke Kbo1 und die untere Klemmbacke Kbu2 auf die Leiterplatte Lp auszuübenden Kontaktdruck aufbringen. Die Stromschienen Sso und Ssu sind an getrennte Gleichrichter angeschlossen, so daß die Stromdichten auf Ober-und Unterseite der Leiterplatten Lp variiert werden können. Die Stromschienen Sso und Ssu können auch in Längsrichtung unterteilt und an verschiedene Gleichrichter angeschlossen werden, so daß beispielsweise im Einlaufbereich der Leiterplatten Lp zur Vermeidung von Verbrennungen geringere Stromdichten eingestellt werden können.

Am rechten Bildrand der Fig. 3 ist das rücklaufende Trum des Kettentriebes mit hier geöffneten Kontaktklemmen Kk1 zu erkennen. Die Blattfedern Bf sind nicht mehr gespannt. Ferner sind zwei Druckfedern Df2 und Df3 angedeutet, welche die Kontaktklemmen Kk1 öffnen, sobald die Blattfedern Bf nicht mehr an den Stromschienen Sso und Ssu anliegen. Zur Begrenzung des Öffnungshubes dienen in die Enden der Mitnehmerstifte Ms1 eingebrachte Splinte Sp.

Gemäß Fig. 3 kann der Rücklauf der geöffneten Kontaktklemmen Kk1 dazu ausgenutzt werden, deren Kontaktflächen Kfo1 und Kfu1 von unerwünschten Metallabscheidungen, Kupferschlamm und ggf. anderen die Kontaktierung beeinträchtigenden Verunreinigungen zu befreien. Hierzu ist in Fig. 3 rein schematisch eine mechanische Reinigungs-Einrichtung RE1 mit einem Bürstenträger Bt und zwei Bürsten Bue dargestellt. Eine Verwendung von federnd gegen die Kontaktflächen Kfo1 und Kfu1 zu drückenden Schleifsteinen ist ebenfalls möglich. An dieser Stelle sei noch erwähnt, daß die übrigen nicht der Kontaktierung dienenden Bereiche der aus Titan bestehenden Kontaktklemmen Kk1 zum Schutz vor unerwünschten Metallabscheidungen mit Polytetrafluoräthylen überzogen sind.

Fig. 4 zeigt die der Kontaktiervorrichtung nach Fig. 3 gegenüberliegende Kontaktiervorrichtung im Bereich eines von einer Welle We in Richtung des Pfeiles Pf7 angetriebenen Ketten-Rades KR. Im übrigen ist die Anordnung der Kontaktiervorrichtungen symmetrisch zur Durchlaufbahn der Leiterplatten.

Fig. 4 zeigt zusätzlich noch eine Variante mit einer chemischen Reinigung der Kontaktklemmen Kk1. Hierzu ist rein schematisch eine Reinigungs-Einrichtung RE2 angedeutet, die eine in Richtung des Pfeiles Pf8 zugeführte Ätzlösung auf die Kontaktflächen Kfo1 und Kfu1 sprüht. Diese Ätzlösung kann dann über eine innerhalb der Galvanisiereinrichtung angeordnete zusätzliche Wanne aufgetragen und erneut der Reinigungs-Einrichtung RE2 zugeführt werden. Die Anordnung eines entsprechenden Ätzmittelbades ist ebenfalls möglich. Hierzu kann der endlose Trieb im Bereich des rücklaufenden Trums entsprechend umgelenkt werden, um ein partielles Eintauchen der zu reinigenden Flächen zu erzielen.

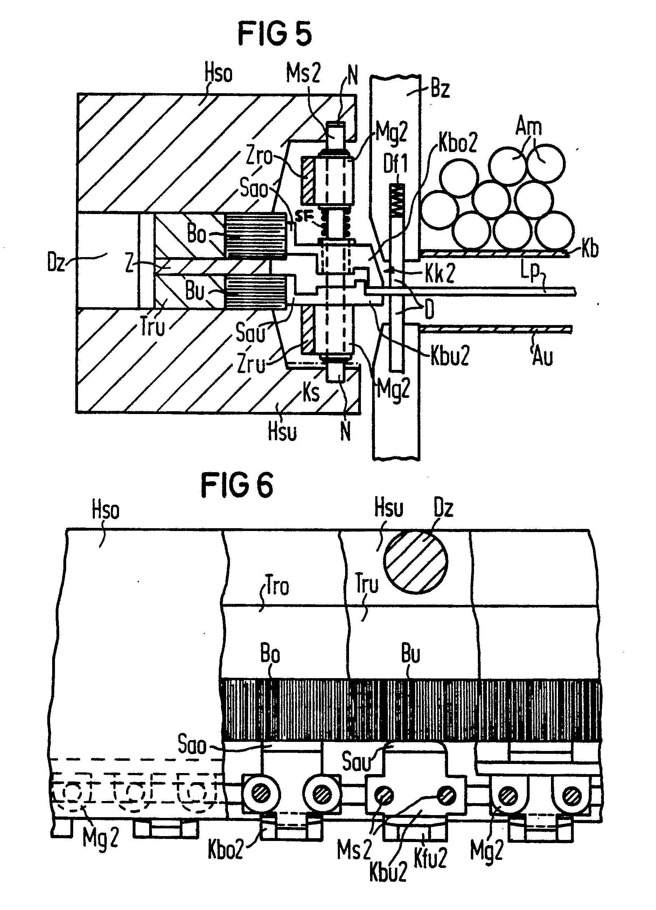

Die Fig. 5 bis 7 zeigen eine zweite Ausführungsform einer in der Galvanisiereinrichtung nach Fig. 2 einsetzbaren Kontaktiervorrichtung. Anstelle einer Kette sind hier ein oberer Zahnriemen Zro und ein unterer Zahnriemen Zru vorgesehen, an welche in gleichmäßiger Teilung Mitnehmerglieder Mg2 angeformt sind. In diesen Mitnehmergliedern Mg2 sind vertikal ausgerichtete Mitnehmerstifte Ms2 gehalten. Die oberen Enden der Mitnehmerstifte Ms2 sind in einer U-förmigen Nut N einer oberen Halteschiene Hso geführt, während die unteren Enden in der entsprechenden Nut N einer unteren Halteschiene Hsu geführt sind. Die obere und die untere Halteschiene Hso und Hsu, die aus hochmolekularen Polyäthylen bestehen, sind über Distanzbolzen Dz fest miteinander verbunden.

Zwischen dem oberen Zahnriemen Zro und dem unteren Zahnriemen Zru sind auf jeweils zwei Mitnehmerstiften Ms2 die oberen Klemmbacken Kbo2 und die unteren Klemmbacken Kbu2 der Kontaktklemmen Kk2 beweglich geführt. Der zum Schließen der Kontaktklemmen Kk2 und zur sicheren Kontaktierung der Leiterplatten Lp erforderliche Druck wird durch Schließfedern Sf aufgebracht, die jeweils zwischen den Mitnehmergliedern Mg2 und den oberen Klemmbacken Kbo2 auf den Mitnehmerstiften Ms2 angeordnet sind.

An die obere Klemmbacke Kbo2 ist rückseitig ein winkelförmiger Stromabnehmer Sao angeformt, der zur Übertragung des Kathodenstroms auf einer oberen Bürste Bo gleitet. In entsprechender Weise ist an die unter Klemmbacke Kbu2 rückseitig ein windelförmiger Stromabnehmer Sau angeformt, der zur Übertragung des Kathodenstroms auf einer unteren Bürste Bu gleitet. Die Bürsten Bo und Bu, die aus einem korrosionsbeständigen Material wie z. B. einen nichtrostenden Stahl bestehen, sind rückseitig mit Trägern Tro bzw. Tru aus Kupfer oder dergl. verbunden und zusammen mit einer isolierenden Zwischenlage Z zwischen den Halteschienen Hso und Hsu festgeklemmt. Durch die geschilderte Art der Stromübertragung mit Stromabnehmern Sao und Sau und Bürsten Bo bzw. Bu sowie durch die Anordnung der Schließfedern Sf können die Kontaktklemmen Kk2 für verschiedene Stärken der Leiterplatten Lp eingeseszt werden, ohne daß sich hierbei der Kontaktdruck wesentlich ändert.

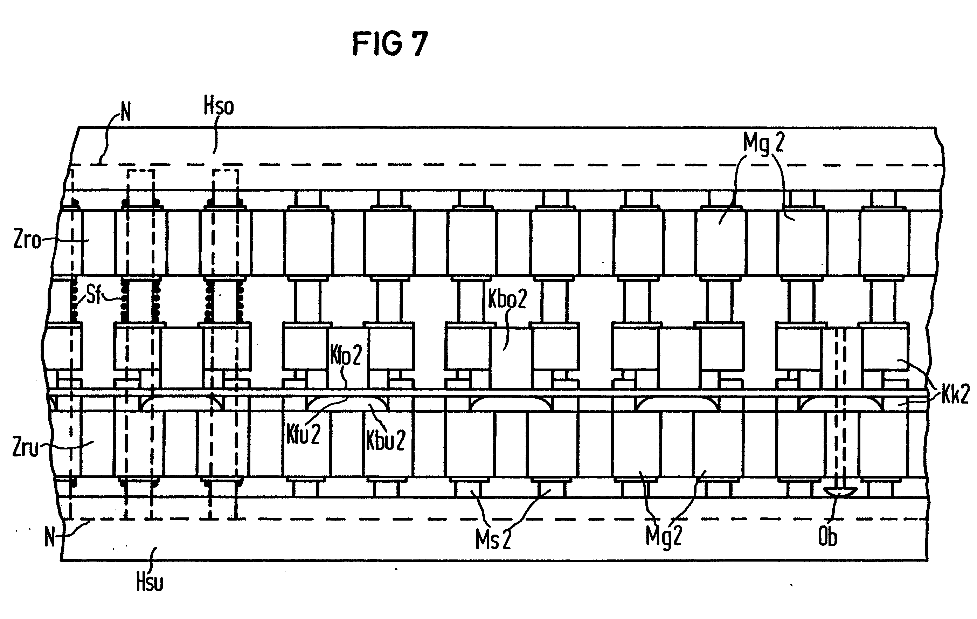

Durch die Ausrüstung der Kontaktklemmen Kk2 mit Schließfedern Sf müssen die Kontaktklemmen Kk2 im Einlaufbereich zum Erfassen der Leiterplatten Lp und im Auslaufbereich zur Freigabe der Leiterplatten Lp zwangsläufig geöffnet werden. Hierzu sind im Ein- und Auslaufbereich der Leiterplatten Kulissensteuerungen vorgesehen, die in Fig. 5 durch die strichpunktierte Linie Ks und in Fig. 7 durch einen Öffnungsbolzen Ob angedeutet sind. Der Kopf eines derartigen Öffnungsbolzens Ob gleitet über der Nut N auf der entsprechenden Schenkelfläche der unteren Halteschiene Hsu. Lediglich im Ein- und Auflaufbereich steigt diese Schenkelfläche raupenartig bis zur Höhe der strichpunktierten Linie Ks an und drückt den Öffnungsbolzen Ob damit nach oben. Der lose durch die untere Klemmbacke Kbu2 hindurchgeführte Öffnungsbolzen Ob hebt dabei die obere Klemmbacke Kbo2 gegen die Kraft der beiden zugeordneten Schließfedern Sf an und öffnet damit die Kontaktklemme Kk2.

Bei der in Fig. 6 gezeigten Draufsicht sind die Kontaktklemmen Kk2 in verschiedenen Höhen geschnitten, so daß an einer Stelle die Form einer unteren Kontaktfläche Kfu2 zu erkennen ist. Im übrigen können die Kontaktflächen Kfo2 und Kfu2 beim Rücklauf der Kontaktklemmen Kk2 auf die bereits im Zusammenhang mit den Figuren 3 und 4 beschriebene Weise gereinigt werden.

## Patentansprüche
### Patentansprüche für folgende Vertragsstaaten : DE, GB, FR, IT, NL, SE, CH, LI, BE

1. Galvanisiereinrichtung für im horizontalen Durchlauf zu behandelnde plattenförmige Werkstücke, insbesondere Leiterplatten, mit mindestens einer in der Elektrolytlösung angeordneten Anode und mit mindestens einer seitlich angeordneten Kontaktiervorrichtung zur kathodischen Kontaktierung der durchlaufenden Werkstücke, wobei die Kontaktiervorrichtung durch eine seitlich mit dem Werkstück verfahrbare, zangenförmige Kontaktklemme (Kk1; Kk2) gebildet ist.

2. Galvanisiereinrichtung nach Anspruch 1, dadurch **gekennzeichnet,** daß mehrere im Abstand zueinander seitlich mit dem Werkstück verfahrbare Kontaktklemmen (Kk1; Kk2) vorgesehen sind.

3. Galvanisiereinrichtung nach Anspruch 1 oder 2, dadurch **gekennzeichnet,** daß zu beiden Seiten der Durchlaufbahn mit dem Werkstück verfahrbare Kontaktklemmen (Kk1; Kk2) vorgesehen sind.

4. Galvanisiereinrichtung nach einem der vorhergehenden Ansprüche, dadurch **gekennzeichnet,** daß auf mindestens einer Seite der Durchlaufbahn mindestens ein endloser Trieb als verfahrbarer Träger zangenförmiger Kontaktklemmen (Kk1; Kk2) angeordnet ist.

5. Galvanisiereinrichtung nach Anspruch 4, dadurch **gekennzeichnet,** daß der endlose Trieb durch eine Kette (Ke) gebildet ist.

6. Galvanisiereinrichtung nach Anspruch 4, dadurch **gekennzeichnet,** daß der endlose Trieb durch mindestens einen Zahnriemen (Zro, Zru) gebildet ist.

7. Galvanisiereinrichtung nach Anspruch 6, dadurch **gekennzeichnet,** daß dem oberen Klemmbacken (Kbo2) der Kontaktklemmen (Kk2) ein oberer Zahnriemen (Zro) zugeordnet ist und daß den unteren Klemmbacken (Kbu2) der Kontaktklemmen (Kk2) ein unterer Zahnriemen (Zru) zugeordnet ist.

8. Galvanisiereinrichtung nach einem der Ansprüche 4 bis 7, dadurch **gekennzeichnet,** daß im Bereich des rücklaufenden Trums des endlosen Triebes mindestens eine Reinigungs-Einrichtung (RE1; RE2) zur mechanischen und/oder chemischen Reinigung der Kontaktflächen (Kfo1, Kfu1; Kfo2, Kfu2) der Kontaktklemmen (Kk1; Kk2) angeordnet ist.

9. Galvanisiereinrichtung nach einem der vorhergehenden Ansprüche, dadurch **gekennzeichnet,** daß der Kathodenstrom den Kontaktklemmen (Kk1; Kk2) mittels Schleifkontaktierung zuführbar ist.

10. Galvanisiereinrichtung nach Anspruch 9, dadurch **gekennzeichnet,** daß der Kathodenstrom der Oberseite und der Unterseite der Werkstücke separat zuführbar ist.

11. Galvanisiereinrichtung nach Anspruch 9 oder 10, dadurch **gekennzeichnet,** daß der Kathodenstrom den beiden Seiten der Werkstücke separat zuführbar ist.

12. Galvanisiereinrichtung nach einem der Ansprüche 9 bis 11, dadurch **gekennzeichnet,** daß der Kathodenstrom in Durchlaufrichtung der Werkstücke gesehen über mindestens zwei separate Längenabschnitte zuführbar ist.

13. Galvanisiereinrichtung nach einem der Ansprüche 9 bis 12, dadurch **gekennzeichnet,** daß der Kathodenstrom den oberen Klemmbacken (Kbo1) der Kontaktklemmen (Kk1) über eine obere Stromschiene (Sso) und den unteren Klemmbacken (Kbu1) der Kontaktklemmen (Kk1) über eine untere Stromschiene (Ssu) zuführbar ist.

14. Galvanisiereinrichtung nach Anspruch 13, dadurch **gekennzeichnet,** daß die obere Stromschiene (Sso) und die untere Stromschiene (Ssu) derat angeordnet sind, daß sie gleichzeitig als Kulisse zum Schließen der Kontaktklemmen (Kk1) im Galvanisierbereich dienen.

15. Galvanisiereinrichtung nach einem der Ansprüche 9 bis 12, dadurch **gekennzeichnet,** daß der Kathodenstrom den oberen Klemmbacken (Kbo2) der Kontaktklemmen (Kk2) über eine sich in Durchlaufrichtung erstreckende obere Bürste (Bo) und den unteren Klemmbacken (Kbu2) der Kontaktklemmen (Kk2) über eine sich in Durchlaufrichtung erstreckende untere Bürste (Bin) zuführbar ist.

16. Galvanisiereinrichtung nach Anspruch 15, dadurch **gekennzeichnet,** daß der oberen Bürste (Bo) an die oberen Klemmbacken (Kbo2) rückseitig angeformte Stromabnehmer (Sao) zugeordnet sind und daß der unteren Bürste (Bu) an die unteren Klemmbacken (Kbu2) rückseitig angeformte Stromabnehmer (Sau) zugeordnet sind.

17. Galvanisiereinrichtung nach einem der Ansprüche 1 bis 13, 15 oder 16, dadurch **gekennzeichnet,** daß der Kontaktdruck einer Kontaktklemme (Kk2) durch eine Schließfeder (Sf) aufbringbar ist und daß zum Öffnen der Kontaktklemme (Kk2) im Einund Auslaufbereich der Werkstücke wirkende Kulissensteuerungen vorgesehen sind.

18. Galvanisiereinrichtung nach Anspruch 17, dadurch **gekennzeichnet,** daß der Kulissensteuerung ein gegen die Kraft der Schließfeder (Sf) wirkender Öffnungsbolzen (Ob) der Kontaktklemme (Kk2) zugeordnet ist.

19. Galvanisiereinrichtung nach einem der vorhergehenden Ansprüche, dadurch **gekennzeichnet,** daß die Kontaktklemmen (Kk1; Kk2) durch eine seitlich sich in Durchlaufrichtung erstreckende und an dem jeweiligen Werkstück anliegende Dichtung (D) vor dem Zutritt von Elektrolytlösung abgeschirmt sind.

**Patentansprüche für folgenden Vertragsstaat : AT**

1. Galvanisiereinrichtung für im horizontalen Durchlauf zu behandelnde plattenförmige Werkstücke, insbesondere Leiterplatten, mit mindestens einer in der Elektrolytlösung angeordneten Anode und mit mindestens einer seitlich angeordneten Kontaktiervorrichtung zur kathodischen Kontaktierung der durchlaufenden Werkstücke, dadurch **gekennzeichnet,** daß die Kontaktiervorrichtung durch eine seitlich mit dem Werkstück verfahrbare, zangenförmige Kontaktklemme (Kk1; Kk2) gebildet ist.

2. Galvanisiereinrichtung nach Anspruch 1, dadurch **gekennzeichnet,** daß mehrere im Abstand zueinander seitlich mit dem Werkstück verfahrbare Kontaktklemmen (Kk1; Kk2) vorgesehen sind.

3. Galvanisiereinrichtung nach Anspruch 1 oder 2, dadurch **gekennzeichnet,** daß zu beiden Seiten der Durchlaufbahn mit dem Werkstück verfahrbare Kontaktklemmen (Kk1; Kk2) vorgesehen sind.

4. Galvanisiereinrichtung nach einem der vorhergehenden Ansprüche, dadurch **gekennzeichnet,** daß auf mindestens einer Seite der Durchlaufbahn mindestens ein endloser Trieb als verfahrbarer Träger zangenförmiger Kontaktklemmen (Kk1; Kk2) angeordnet ist.

5. Galvanisiereinrichtung nach Anspruch 4, dadurch **gekennzeichnet,** daß der endlose Trieb durch eine Kette (Ke) gebildet ist.

6. Galvanisiereinrichtung nach Anspruch 4, dadurch **gekennzeichnet,** daß der endlose Trieb durch mindestens einen Zahnriemen (Zro, Zru) gebildet ist.

7. Galvanisiereinrichtung nach Anspruch 6, dadurch **gekennzeichnet,** daß dem oberen Klemmbacken (Kbo2) der Kontaktklemmen (Kk2) ein oberer Zahnriemen (Zro) zugeordnet ist und daß den unteren Klemmbacken (Kbu2) der Kontaktklemmen (Kk2) ein unterer Zahnriemen (Zru) zugeordnet ist.

8. Galvanisiereinrichtung nach einem der Ansprüche 4 bis 7, dadurch **gekennzeichnet,** daß der endlose Trieb antreibbar ist und mit den zangenförmigen Kontaktklemmen (Kk1; Kk2) als Mitnehmer eine Transporteinrichtung für den horizontalen Durchlauf der Werkstücke bildet.

9. Galvanisiereinrichtung nach einem der Ansprüche 4 bis 8, dadurch **gekennzeichnet,** daß im Bereich des rücklaufenden Trums des endlosen Triebes mindestens eine Reinigungs-Einrichtung (RE1; RE2) zur mechanischen und/oder chemischen Reinigung der Kontaktflächen (Kfo1, Kfu1; Kfo2, Kfu2) der Kontaktklemmen (Kk1; Kk2) angeordnet ist.

10. Galvanisiereinrichtung nach einem der vorhergehenden Ansprüche, dadurch **gekennzeichnet,** daß der Kathodenstrom den Kontaktklemmen (Kk1; Kk2) mittels Schleifkontaktierung zuführbar ist.

11. Galvanisiereinrichtung nach Anspruch 10, dadurch **gekennzeichnet,** daß der Kathodenstrom der Oberseite und der Unterseite der Werkstücke separat zuführbar ist.

12. Galvanisiereinrichtung nach Anspruch 10 oder 11, dadurch **gekennzeichnet,** daß der Kathodenstrom den beiden Seiten der Werkstücke separat zuführbar ist.

13. Galvanisiereinrichtung nach einem der Ansprüche 10 bis 12, dadurch **gekennzeichnet,** daß der Kathodenstrom in Durchlaufrichtung der Werkstücke gesehen über mindestens zwei separate Längenabschnitte zuführbar ist.

14. Galvanisiereinrichtung nach einem der Ansprüche 10 bis 13, dadurch **gekennzeichnet,** daß der Kathodenstrom den oberen Klemmbacken (Kbo1) der Kontaktklemmen (Kk1) über eine obere Stromschiene (Sso) und den unteren Klemmbacken (Kbu1) der Kontaktklemmen (Kk1) über eine untere Stromschiene (Ssu) zuführbar ist.

15. Galvanisiereinrichtung nach Anspruch 14, dadurch **gekennzeichnet,** daß die obere Stromschiene (Sso) und die untere Stromschiene (Ssu) derat angeordnet sind, daß sie gleichzeitig als Kulisse zum Schließen der Kontaktklemmen (Kk1) im Galvanisierbereich dienen.

16. Galvanisiereinrichtung nach einem der Ansprüche 10 bis 13, dadurch **gekennzeichnet,** daß der Kathodenstrom den oberen Klemmbacken (Kbo2) der Kontaktklemmen (Kk2) über eine sich in Durchlaufrichtung erstreckende obere Bürste (Bo) und den unteren Klemmbacken (Kbu2) der Kontaktklemmen (Kk2) über eine sich in Durchlaufrichtung erstreckende untere Bürste (Bu) zuführbar ist.

17. Galvanisiereinrichtung nach Anspruch 16, dadurch **gekennzeichnet,** daß der oberen Bürste (Bo) an die oberen Klemmbacken (Kbo2) rückseitig angeformte Stromabnehmer (Sao) zugeordnet sind und daß der unteren Bürste (Bu) an die unteren Klemmbacken (Kbu2) rückseitig angeformte Stromabnehmer (Sau) zugeordnet sind.

18. Galvanisiereinrichtung nach einem der Ansprüche 1 bis 14, 16 oder 17, dadurch **gekennzeichnet,** daß der Kontaktdruck einer Kontaktklemme (Kk2) durch eine Schließfeder (Sf) aufbringbar ist und daß zum Öffnen der Kontaktklemme (Kk2) im Ein-und Auslaufbereich der Werkstücke wirkende Kulissensteuerungen vorgesehen sind.

19. Galvanisiereinrichtung nach Anspruch 18, dadurch **gekennzeichnet,** daß der Kulissensteuerung ein gegen die Kraft der Schließfeder (Sf) wirkender Öffnungsbolzen (Ob) der Kontaktklemme (Kk2) zugeordnet ist.

20. Galvanisiereinrichtung nach einem der vorhergehenden Ansprüche, dadurch **gekennzeichnet,** daß die Kontaktklemmen (Kk1; Kk2) durch eine seitlich sich in Durchlaufrichtung erstrekkende und an dem jeweiligen Werkstück anliegende Dichtung (D) vor dem Zutritt von Elektrolytlösung abgeschirmt sind.

## Claims
## Claims for the following Contracting States : DE, GB, FR, IT, NL, SE, CH, LI, BE

1. Electroplating apparatus for workpieces to be treated in horizontal flow, preferably printed circuit boards, having at least one anode arranged in the electrolyte solution and having at least one laterally arranged contact device for making cathodic contact to the workpieces passing through, the contact device being formed by a tong-shaped contact terminal (Kk1; Kk2) which can be conveyed laterally with the workpiece.

2. Electroplating apparatus according to Claim 1, characterised in that a plurality of contact terminals (Kk1; Kk2) which can be conveyed laterally with the workpiece are provided at a distance from one another.

3. Electroplating apparatus according to Claim 1 or 2, characterised in that contact terminals (Kk1; Kk2) which can be conveyed laterally with the workpiece are provided on both sides of the flow path.

4. Electroplating apparatus according to one of the preceding claims, characterised in that at least one endless drive is arranged on at least one side of the flow path, as a conveyable carrier of tong-shaped contact terminals (Kk1; Kk2).

5. Electroplating apparatus according to Claim 4, characterised in that the endless drive is formed by a chain (Ke).

6. Electroplating apparatus according to Claim 4, characterised in that the endless drive is formed by at least one toothed belt (Zro, Zru).

7. Electroplating apparatus according to Claim 6, characterised in that an upper toothed belt (Zro) is allocated to the upper clamping jaws (Kbo2) of the contact terminals (Kk2) and in that a lower toothed belt (Zru) is allocated to the lower clamping jaws (Kbu2) of the contact terminals (Kk2).

8. Electroplating apparatus according to one of Claims 4 to 7, characterised in that at least one cleaning apparatus (RE1; RE2) is arranged in the region of the returning strand of the endless drive for the mechanical and/or chemical cleaning of the contact surfaces (Kfo1, Kfu1; Kfo2, Kfu2) of the contact terminals (Kk1; Kk2).

9. Electroplating apparatus according to one of the preceding claims, characterised in that the cathode current can be supplied to the contact terminals (Kk1; Kk2) by means of a sliding contact.

10. Electroplating apparatus according to Claim 9, characterised in that the cathode current can be supplied separately to the upper side and to the lower side of the workpieces.

11. Electroplating apparatus according to Claim 9 or 10, characterised in that the cathode current can be supplied separately to both sides of the workpieces.

12. Electroplating apparatus according to one of Claims 9 to 11, characterised in that the cathode current can be supplied via at least two separate longitudinal sections, seen in the direction of flow of the workpieces.

13. Electroplating apparatus according to one of Claims 9 to 12, characterised in that the cathode current can be supplied to the upper clamping jaws (Kbo1) of the contact terminals (Kk1) via an upper live rail (Sso) and can be supplied to the lower clamping jaws (Kbu1) of the contact terminals (Kk1) via a lower live rail (Ssu).

14. Electroplating apparatus according to Claim 13, characterised in that the upper live rail (Sso) and the lower live rail (Ssu) are arranged in a manner such that they are used at the same time as detents for closing the contact terminals (Kk1) in the electroplating area.

15. Electroplating apparatus according to one of Claims 9 to 12, characterised in that the cathode current can be supplied to the upper clamping jaws (Kbo2) of the contact terminals (Kk2) via an upper brush (Bo) extending in the direction of flow, and can be supplied to the lower clamping jaws (Kbu2) of the contact terminals (Kk2) via a lower brush (Bu) extending in the direction of flow.

16. Electroplating apparatus according to Claim 15, characterised in that current pick-offs (Sao), integrally formed on the rear of the upper clamping jaws (Kbo2), are allocated to the upper brush (Bo), and in that current pick-offs [Sau], integrally formed on the rear of the lower clamping jaws (Kbu2), are allocated to the lower brush (Bu).

17. Electroplating apparatus according to one of Claims 1 to 13, 15 or 16, characterised in that the contact pressure of a contact terminal (Kk2) can be applied by a locking spring (Sf), and in that detent controls are provided, acting to open the contact terminal (Kk2) in the inflow and outflow area of the workpieces.

18. Electroplating apparatus according to Claim 17, characterised in that an opening bolt (Ob) of the contact terminal (Kk2), acting against the force of the locking spring (Sf ), is allocated to the detent control.

19. Electroplating apparatus according to one of the preceding claims, characterised in that the contact terminals (Kk1; Kk2) are screened against the ingress of electrolyte solution by means of a seal (D) abutting against the respective workpiece and extending laterally in the direction of flow.

**Claims for the following Contracting State : AT**

1. Electroplating apparatus for workpieces to be treated in horizontal flow, preferably printed circuit boards, having at least one anode arranged in the electrolyte solution and having at least one laterally arranged contact device for making cathodic contact with the workpieces passing through, characterised in that the contact device is formed by a tong-shaped contact terminal (Kk1; Kk2) which can be conveyed laterally with the workpiece.

2. Electroplating apparatus according to Claim 1, characterised in that a plurality of contact terminals (Kk1; Kk2) which can be conveyed laterally with the workpiece are provided at a distance from one another.

3. Electroplating apparatus according to Claim 1 or 2, characterised in that contact terminals (Kk1; Kk2) which can be conveyed laterally with the workpiece are provided on both sides of the flow path.

4. Electroplating apparatus according to one of the preceding claims, characterised in that at least one endless drive is arranged on at least one side of the flow path, as a conveyable carrier of tong-shaped contact terminals (Kk1; Kk2).

5. Electroplating apparatus according to Claim 4, characterised in that the endless drive is formed by a chain (Ke).

6. Electroplating apparatus according to Claim 4, characterised in that the endless drive is formed by at least one toothed belt (Zro, Zru).

7. Electroplating apparatus according to Claim 6, characterised in that an upper toothed belt (Zro) is allocated to the upper clamping jaws (Kbo2) of the contact terminals (Kk2) and in that a lower toothed belt (Zru) is allocated to the lower clamping jaws (Kbu2) of the contact terminals (Kk2).

8. Electroplating apparatus according to one of Claims 4 to 7, characterised in that the endless drive can be driven and forms a transportation apparatus for the horizontal flow of the workpieces, with the tong-shaped contact terminals (Kk1; Kk2) as drive catches.

9. Electroplating apparatus according to one of Claims 4 to 8, characterised in that at least one cleaning apparatus (RE1; RE2) is arranged in the region of the returning strand of the endless drive for the mechanical and/or chemical cleaning of the contact surfaces (Kfo1, Kfu1; Kfo2, Kfu2) of the contact terminals (Kk1; Kk2).

10. Electroplating apparatus according to one of the preceding claims, characterised in that the cathode current can be supplied to the contact terminals (Kk1; Kk2) by means of a sliding contact.

11. Electroplating apparatus according to Claim 10, characterised in that the cathode current can be supplied separately to the upper side and to the lower side of the workpieces.

12. Electroplating apparatus according to Claim 10 or 11, characterised in that the cathode current can be supplied separately to both sides of the workpieces.

13. Electroplating apparatus according to one of Claims 10 to 12, characterised in that the cathode current can be supplied via at least two separate longitudinal sections, seen in the direction of flow of the workpieces.

14. Electroplating apparatus according to one of Claims 10 to 13, characterised in that the cathode current can be supplied to the upper clamping jaws (Kbo1) of the contact terminals (Kk1) via an upper live rail (Sso) and can be supplied to the lower clamping jaws (Kbu1) of the contact terminals (Kk1) via a lower live rail (Ssu).

15. Electroplating apparatus according to Claim 14, characterised in that the upper live rail (Sso) and the lower live rail (Ssu) are arranged in a manner such that they are used at the same time as detents for closing the contact terminals (Kk1) in the electroplating area.

16. Electroplating apparatus according to one of Claims 10 to 13, characterised in that the cathode current can be supplied to the upper clamping jaws (Kbo2) of the contact terminals (Kk2) via an upper brush (Bo) extending in the direction of flow, and can be supplied to the lower clamping jaws (Kbu2) of the contact terminals (Kk2) via a lower brush (Bu) extending in the direction of flow.

17. Electroplating apparatus according to Claim 16, characterised in that current pick-offs (Sao), integrally formed on the rear of the upper clamping jaws (Kbo2), are allocated to the upper brush (Bo), and in that current pick-offs (Sau), integrally formed on the rear of the lower clamping jaws (Kbu2), are allocated to the lower brush (Bu).

18. Electroplating apparatus according to one of Claims 1 to 14, 16 or 17, characterised in that the contact pressure of a contact terminal (Kk2) can be applied by a locking spring (Sf), and in that detent controls are provided, acting to open the contact terminal (Kk2) in the inflow and outflow area of the workpieces.

**19.** Electroplating apparatus according to Claim 18, characterised in that an opening bolt (Ob) of the contact terminal (Kk2), acting against the force of the locking spring (Sf), is allocated to the detent control.

**20.** Electroplating apparatus according to one of the preceding claims, characterised in that the contact terminals (Kk1; Kk2) are screened against the ingress of electrolyte solution by means of a seal (D) abutting against the respective workpiece and extending laterally in the direction of flow.

**Revendications**
**Revendications pour les Etats contractants suivants : DE, GB, FR, IT, NL, SE, CH, LI, BE**

**1.** Dispositif de galvanisation pour des pièces en forme de plaques, qui doivent être traitées lors de leur transfert horizontal, notamment des plaquettes à circuits imprimés, comportant au moins une anode disposée dans la solution électrolytique, et au moins un dispositif de contact disposé latéralement et servant à réaliser le contact cathodique avec les pièces à traiter traversant le dispositif, le dispositif de contact étant formé par une borne de contact en forme de pince (Kk1; Kk2), déplaçable latéralement avec la pièce à traiter.

**2.** Dispositif de galvanisation suivant la revendication 1, caractérisé par le fait qu'il est prévu plusieurs bornes de contact (kk1; Kk2) déplaçables latéralement, avec la pièce à traiter, en étant distantes l'une de l'autre.

**3.** Dispositif de galvanisation suivant la revendication 1 ou 2, caractérisé par le fait que les bornes de contact (Kk1; Kk2) déplaçables avec la pièce à traiter sont prévues des deux côtés de la voie de transfert.

**4.** Dispositif de galvanisation suivant l'une des revendications précédentes, caractérisé par le fait qu'au moins un dispositif d'entraînement sans fin servant de support mobile pour les bornes de contact en forme de pinces (Kk1; Kk2) est disposé au moins d'un côté de la voie de transfert.

**5.** Dispositif de galvanisation suivant la revendication 4, caractérisé par le fait que le dispositif d'entraînement sans fin est constitué par une chaîne (Ke).

**6.** Dispositif de galvanisation suivant la revendication 4, caractérisé par le fait que le dispositif d'entraînement sans fin est formé par au moins une courroie dentée (Zro, Zru).

**7.** Dispositif de galvanisation suivant la revendication 6, caractérisé par le fait qu'une courroie dentée supérieure (Zro) est associée à la mâchoire supérieure de serrage (Kbo2) des bornes de contact (Kk2) et qu'une courroie dentée inférieure (Zru) est associée aux mâchoires inférieures de serrage (Kbu2) des bornes de contact (Kk2).

**8.** Dispositif de galvanisation suivant l'une des revendications 4 à 7, caractérisé par le fait qu'au moins un dispositif de nettoyage (RE1; RE2) servant à réaliser le nettoyage mécanique et/ou chimique des surfaces de contact (Kfo1, Kfu1; Kfo2, Kfu2) des bornes de contact (Kk1; Kk2) est disposé au voisinage du brin de retour du dispositif d'entraînement sans fin.

**9.** Dispositif de galvanisation suivant l'une des revendications précédentes, caractérisé par le fait que le courant cathodique peut être envoyé aux bornes de contact (Kk1; Kk2) par l'intermédiaire d'un contact glissant.

**10.** Dispositif de galvanisation suivant la revendication 9, caractérisé par le fait que le courant cathodique peut être envoyé séparément à la face supérieure et à la face inférieure des pièces à traiter.

**11.** Dispositif de galvanisation suivant la revendication 9 ou 10, caractérisé par le fait que le courant cathodique peut être envoyé séparément aux deux faces des pièces à traiter.

**12.** Dispositif de galvanisation suivant l'une des revendications 9 à 11, caractérisé par le fait que le courant cathodique peut être envoyé sur au moins deux éléments de longueur séparés, lorsqu'on regarde dans la direction de transfert des pièces à traiter.

**13.** Dispositif de galvanisation suivant l'une des revendications 9 à 12, caractérisé par le fait que le courant cathodique peut être envoyé aux mâchoires supérieures de serrage (Kbo1) des bornes de contact (Kk1) par l'intermédiaire d'un rail conducteur supérieur (Sso) et aux mâchoires inférieures de serrage (Kbu1) des bornes de contact (Kk1) par l'intermédiaire d'un rail conducteur inférieur (Ssu).

**14.** Dispositif de galvanisation suivant la revendication 13, caractérisé par le fait que le rail supérieur conducteur (Sso) et le rail conducteur inférieur (Ssu) sont disposés de telle sorte qu'ils servent simultanément de coulisses pour la fermeture des bornes de contact (Kk1) dans la zone de galvanisation.

15. Dispositif de galvanisation suivant l'une des revendications 9 à 12, caractérisé par le fait que le courant cathodique peut être envoyé aux mâchoires supérieures de serrage (Kbo2) des bornes de contact (Kk2) par l'intermédiaire d'une brosse supérieure (Bo) qui s'étend dans la direction de transfert, et aux mâchoires inférieures de serrage (Kbu2) des bornes de contact (Kk2) par l'intermédiaire d'une brosse inférieure (Bu) qui s'étend dans la direction de transfert.

16. Dispositif de galvanisation suivant la revendication 15, caractérisé par le fait que des organes (Sao) de prélèvement du courant, formés par moulage sur le côté arrière des mâchoires supérieures de serrage (Kbo2), sont associés à la broche supérieure (Bo) et que des organes (Sau) de prélèvement de courant, formés par moulage sur la face arrière des mâchoires inférieures de serrage (Kbu2) sont associés à la brosse inférieure (Bu).

17. Dispositif de galvanisation suivant l'une des revendications 1 à 13, 15 ou 16, caractérisé par le fait que la pression de contact peut être appliquée à une borne de contact (Kk2) par l'intermédiaire d'un ressort de fermeture (Sf), et que pour l'ouverture de la borne de contact (Kk2), il est prévu des dispositifs de commande à coulisse agissant dans les zones d'entrée et de sortie des pièces à traiter.

18. Dispositif de galvanisation suivant la revendication 17, caractérisé par le fait qu'au dispositif de commande à coulisse est associé une broche d'ouverture (Ob), qui agit à l'encontre de la force du ressort de fermeture (Sf), de la borne de contact (Kk2).

19. Dispositif de galvanisation suivant l'une des revendications précédentes, caractérisé par le fait que les bornes de contact (Kk1; Kk2) sont protégés vis-à-vis de la pénétration de la solution électrolytique, par une garniture d'étanchéité (D) qui s'étend latéralement dans la direction de transfert et s'applique contre la pièce à traiter respective.

**Revendications pour l'Etat contractant suivant : AT**

1. Dispositif de galvanisation pour des pièces en forme de plaques, qui doivent être traitées lors de leur transfert horizontal, notamment des plaquettes à circuits imprimés, comportant au moins une anode disposée dans la solution électrolytique, et au moins un dispositif de contact disposé latéralement et servant à réaliser le contact cathodique avec les pièces à traiter traversant le dispositif, caractérisé par le fait que le dispositif de contact est formé par une borne de contact en forme de pince (Kk1; Kk2), déplaçable latéralement avec la pièce à traiter.

2. Dispositif de galvanisation suivant la revendication 1, caractérisé par le fait qu'il est prévu plusieurs bornes de contact (Kk1; Kk2) déplaçables latéralement, avec la pièce à traiter, en étant distantes l'une de l'autre.

3. Dispositif de galvanisation suivant la revendication 1 ou 2, caractérisé par le fait que les bornes de contact (Kk1; Kk2) déplaçables avec la pièce à traiter sont prévues des deux côtés de la voie de transfert.

4. Dispositif de galvanisation suivant l'une des revendications précédentes, caractérisé par le fait qu'au moins un dispositif d'entraînement sans fin servant de support mobile pour les bornes de contact en forme de pinces (Kk1; Kk2) est disposé au moins d'un côté de la voie de transfert.

5. Dispositif de galvanisation suivant la revendication 4, caractérisé par le fait que le dispositif d'entraînement sans fin est constitué par une chaîne (Ke).

6. Dispositif de galvanisation suivant la revendication 4, caractérisé par le fait que le dispositif d'entraînement sans fin est formé par au moins une courroie dentée (Zro, Zru).

7. Dispositif de galvanisation suivant la revendication 6, caractérisé par le fait qu'une courroie dentée supérieure (Zro) est associée à la mâchoire supérieure de serrage (Kbo2) des bornes de contact (Kk2) et qu'une courroie dentée inférieure (Zru) est associée aux mâchoires inférieures de serrage (Kbu2) des bornes de contact (Kk2).

8. Dispositif de galvanisation suivant l'une des revendications 4 à 7, caractérisé par le fait que le dispositif d'entraînement sans fin peut être entraîné et forme, avec les bornes de contact en forme de pinces (Kk1; Kk2) constituant des organes d'entraînement, un dispositif de transport pour le transfert horizontal des pièces à traiter.

9.  Dispositif de galvanisation suivant l'une des revendications 4 à 8, caractérisé par le fait que dans la zone du brin de retour du dispositif d'entraînement sans fin est disposé au moins un dispositif de nettoyage (RE1; RE2) servant à réaliser un nettoyage mécanique et/ou chimique des surfaces de contact (Kfo1, Kfu1; Kfo2, Kfu2) des bornes de contact (Kk1; Kk2).

10.  Dispositif de galvanisation suivant l'une des revendications précédentes, caractérisé par le fait que le courant cathodique des bornes de contact (Kk1; Kk2) peut être introduit au moyen d'un contact glissant.

11.  Dispositif de galvanisation suivant la revendication 10, caractérisé par le fait que le courant cathodique peut être envoyé séparément à la face supérieure et à la face inférieure des pièces à traiter.

12.  Dispositif de galvanisation suivant la revendication 10 ou 11, caractérisé par le fait que le courant cathodique peut être envoyé séparément aux deux faces de la pièce à traiter.

13.  Dispositif de galvanisation suivant l'une des revendications 10 à 12, caractérisé par le fait que le courant cathodique peut être envoyé sur au moins deux éléments de longueur séparés, dans la direction de transfert des pièces à traiter.

14.  Dispositif de galvanisation suivant l'une des revendications 10 à 13, caractérisé par le fait que le courant cathodique peut être envoyé aux mâchoires supérieures de serrage (Kbo1) des bornes de contact (Kk1) par l'intermédiaire d'un rail conducteur supérieur (Sso) et aux mâchoires inférieures de serrage (Kbu1) des bornes de contact (Kk1) par l'intermédiaire d'un rail conducteur inférieur (Ssu).

15.  Dispositif de galvanisation suivant la revendication 14, caractérisé par le fait que le rail conducteur supérieur (Sso) et le rail conducteur inférieur (Ssu) sont disposés de telle sorte qu'ils servent simultanément de coulisses pour fermer les bornes de contact (Kk1) dans la zone de galvanisation.

16.  Dispositif de galvanisation suivant l'une des revendications 10 à 13, caractérisé par le fait que le courant cathodique peut être envoyé aux mâchoires supérieures de serrage (Kbo2) des bornes de contact (Kk2) par l'intermédiaire d'une brosse supérieure (Bo), qui s'étend dans la direction de transfert, et aux mâchoires inférieures de serrage (Kbu2) des bornes de contact (Kk2) par l'intermédiaire d'une broche inférieure (Bu) qui s'étend dans la direction de transfert.

17.  Dispositif de galvanisation suivant la revendication 16, caractérisé par le fait que des organes (Sae) de prélèvement du courant, formés par moulage sur le côté arrière des mâchoires supérieures de serrage (Kbo2) sont associés à la brosse supérieure (Bo) et que des organes (Sau) de prélèvement de courant formés par moulage sur le côté arrière des mâchoires inférieures de serrage (Kbu2) sont associés à la brosse inférieure (Bu).

18.  Dispositif de galvanisation suivant l'une des revendications 1 à 14, 16 ou 17, caractérisé par le fait que la pression de contact peut être appliquée à une borne de contact (Kk2) au moyen d'un ressort de fermeture (Sf) et que pour l'ouverture de la borne de contact (Kk2), il est prévu des dispositifs de commande à coulisse agissant dans les zones d'entrée et de sortie des pièces à traiter.

19.  Dispositif de galvanisation suivant la revendication 18, caractérisé par le fait qu'à l'unité de commande à coulisse est associé une broche d'ouverture (Ob), agissant à l'encontre de la force du ressort de fermeture (Sf), de la borne de contact (Kk2).

20.  Dispositif de galvanisation suivant l'une des revendications précédentes, caractérisé par le fait que les bornes de contact (Kk1; Kk2) sont protégées vis-à-vis de la pénétration de la solution électrolytique par une garniture d'étanchéité (D) qui s'étend latéralement dans une direction de transfert et s'applique contre la pièce à traiter respective.

# FIG 1

# FIG 2

# FIG 3

# FIG 4

EP 0 254 962 B1

## FIG 5

## FIG 6

FIG 7